# EUROPEAN PATENT APPLICATION

(11) **EP 1 761 114 A2**
(43) Date of publication of application: **07.03.2007**
(21) Application number: 06119700.0
(22) Date of filing: 29.08.2006
(51) Int. Cl.: H05K 1/02

(54) **Circuit board**

(30) Priority: 31.08.2005 JP 2005252394; 09.09.2005 JP 2005262485
(71) Applicant: KABUSHIKI KAISHA TOYOTA JIDOSHOKKI, Kariya-shi, Aichi 448-8671 (JP)
(72) Inventor: Sugiyama, Tomohei, Kariya-shi Aichi 448-8671 (JP); Kinoshita, Kyoichi, Kariya-shi Aichi 448-8671 (JP); Tanaka, Katsufumi, Kariya-shi Aichi 448-8671 (JP); Kono, Eiji, Kariya-shi Aichi 448-8671 (JP)
(74) Representative: TBK-Patent

(57) **Abstract**

A circuit board (10) includes a substrate (11) having a heat exhausting function. A wiring layer (12, 230) of a metal composite material is provided on the substrate (11) with an insulating layer (13) in between. The metal composite material has a coefficient of thermal expansion that is greater than a coefficient of thermal expansion of a silicon semiconductor chip (18) and less than a coefficient of thermal expansion of copper. Accordingly, a circuit board that is suitable for mounting power devices, requires no heat sink or heat spreader is provides. Further, the number of components for assembling a module is reduced (Fig. 1A).

## Description

### BACKGROUND OF THE INVENTION

The present invention relates to a circuit board on which semiconductor devices and electronic components are mounted.

Typically, a heat sink is used for radiating heat generated by semiconductor devices and electronic components mounted on a circuit board. When a metal heat sink is employed, a great difference between the coefficient of thermal expansion of the metal of the heat sink and coefficients of thermal expansion of the components such as semiconductor devices shortens the life of the circuit board in cooling-heating cycles. Accordingly, Japanese Laid-Open Patent Publication No. 10-65075 discloses a ceramic circuit board having a heat sink made of an AlSiC based composite material. First and second aluminum plates are laminated and bonded onto both sides of the ceramic substrate, respectively, with an Al-Si based brazing filler metal. A heat sink made of an AlSi based composite material is laminated and bonded onto the surface of the first aluminum plate. A predetermined circuit pattern is formed on the second aluminum plate through etching.

Japanese Laid-Open Patent Publication No. 7-106770 discloses a multilayer printed wiring board that has a high connection reliability with compact and thin electronic components, and is capable of highly densely mounting electronic components. The multilayer printed wiring board includes a plurality of printed boards and insulating substrates located between the printed boards. The insulating substrates are made of a mixture of a synthetic resin and sub materials such as fibers and particles. Each printed board is formed of traces on the surface of the insulating substrate. At least the outermost traces in the multilayer printed wiring board are made of a metal having a coefficient of thermal expansion less than a coefficient of thermal expansion of the insulating substrates. The metal may be the 42 alloy, Kovar, a copper-invar-copper alloy, or stainless steel.

The apparatus disclosed in Japanese Laid-Open Patent Publication No. 10-65075 has a relatively great number of components since a heat sink is required in addition to the ceramic circuit substrate. Also, when semiconductor devices and electronic components mounted on the circuit board do not generate a great amount of heat, radiation of heat from the heat sink is sufficient for achieving a required heat radiating performance. However, when a great amount of heat is generated, the heat sink needs to be connected to a cooling portion having a higher cooling performance. Cooling portions having a high cooling performance include a case or a block having a passage through which cooling medium flows. In such a case, the heat sink is fastened, for example, to a case with screws. To fill gaps between the facing surfaces of the heat sink and the case, a grease layer is provided between the heat sink and the case. The thermal conductivity of grease is relatively low as 0.8 W/(mK). As a result, the thermal resistance between the heat sink and the cooling portion is increased. This prevents high current semiconductor devices from being used and hinders a miniaturization of the module.

Japanese Laid-Open Patent Publication No. 7-106770 also discloses the formation of traces on the surface of an insulating substrate, the traces being made of a metal having a coefficient of thermal expansion less than the coefficient of thermal expansion of the insulating substrate. However, the publication recites that the objective of using a metal of less coefficient of thermal expansion than the coefficient of thermal expansion of the insulating substrate for the traces is to reduce the difference between the coefficient of thermal expansion of the metal traces and the coefficient of thermal expansion of the insulating substrate. The publication discloses no consideration for heat radiation performance. For example, if the metal traces are formed of 42 alloy or Kovar, the heat radiation performance is degraded since the thermal conductivity of these alloys is no more than 10 W/(mK).

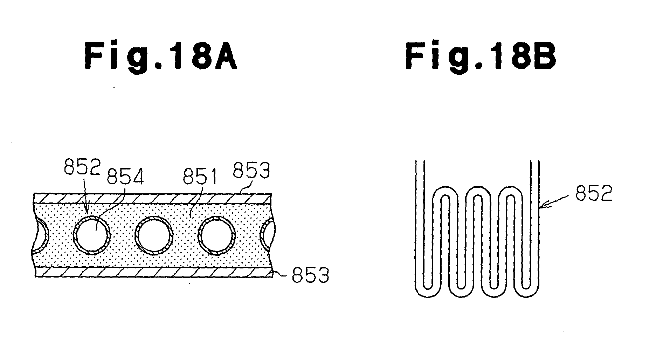

Japanese Laid-Open Patent Publication No. 5-299788 discloses a printed wiring board having a superior heat radiation performance, and capable of having through holes. As shown in Fig. 18A, the printed wiring board includes an insulating layer 851 made of a thermosetting resin and conductors 853 provided on both sides of the insulating layer 851. Each conductor 853 functions as a wiring layer for forming circuits. A cooling device 852 through which a heat medium flows is embedded in the insulating layer 851. The cooling device 852 is formed, for example, by bending a pipe as shown in Fig. 18B. Through holes (not shown) may be formed in sections of the insulating layer 851 between sections of a channel 854 of a cooling medium of the cooling device 852. By mixing various types of fillers with the thermosetting resin of the insulating layer 851, the thermal conductivity of the thermosetting resin can be improved and the coefficient of thermal expansion can be equalized with a coefficient of thermal expansion of the cooling device 852.

The printed wiring board disclosed in Japanese Laid-Open Patent Publication No. 5-299788 has the cooling device 852 through which a heat medium flows. This permits the size of the substrate to be reduced compared to the case where a heat sink is provided. Also, compared to a printed circuit board having no heat sink, the printed circuit board of the publication has a superior heat radiation performance. However, in the printed circuit board of the publication, heat of the conductors 853 shown in Fig. 18A is transferred to the outer surface of the pipe forming the channel 854 through the insulating layer 851. Thereafter, the heat is transferred through the pipe to the heat medium. The heat medium, which flows through the channel 854, removes the heat from the insulating layer 851. Therefore, the heat radiation performance, or the cooling performance, of the conductors 853 can be changed depending on the arrangement of the pipe relative to the conductors 853. That is, compared to sections close to the pipe, sections spaced from the pipe or sections that do not face the pipe have a relatively low heat radiation performance. In the case where the thickness of the thinnest section of the insulating layer 851 located between the conductors 853 and sections of the pipe is set to several tens of micrometers, it is difficult to flatten the surfaces of the insulating layer 851 each facing one of the conductor 853 during the formation of the insulating layer 851.

### SUMMARY OF THE INVENTION

Accordingly, it is an objective of the present invention to provide a circuit board that is suitable for mounting semiconductor devices generating a great amount of heat such as power devices, requires no heat sink or heat spreader, and is capable of reducing the number of components for assembling a module.

Another objective of the present invention is to provide a circuit board that has an improved heat radiation performance compared to the prior art, permits a wiring layer to be easily flattened, and improves the reliability of soldered joints.

According to one aspect of the invention, a circuit board including a substrate having a heat exhausting function is provided. A wiring layer of a metal composite material is provided on the substrate with an insulating layer in between. The metal composite material has a coefficient of thermal expansion that is greater than a coefficient of thermal expansion of a silicon semiconductor chip and less than a coefficient of thermal expansion of copper.

Further, according to another aspect of the invention, a circuit board including a substrate having a resin area formed of resin is provided. A metal cooling portion is embedded in the resin area. The cooling portion has a cooling medium passage. The resin area has a coefficient of thermal expansion smaller than a coefficient of thermal expansion of the cooling portion. A wiring layer is provided on the substrate with an insulating layer in between. A silicon semiconductor chip is mountable on the wiring layer. At least a section of the cooling portion that corresponds to the wiring layer has a flat portion.

Other aspects and advantages of the invention will become apparent from the following description, taken in conjunction with the accompanying drawings, illustrating by way of example the principles of the invention.

### BRIEF DESCRIPTION OF THE DRAWINGS

The invention, together with objects and advantages thereof, may best be understood by reference to the following description of the presently preferred embodiments together with the accompanying drawings in which:
Fig. 1A is a schematic cross-sectional view illustrating a circuit board according to a first embodiment of the present invention;
Fig. 1B is a partially enlarged cross-sectional view of the wiring layer shown in Fig. 1A;
Fig. 2 is a diagrammatic view illustrating a state in which the circuit board of Fig. 1A is assembled with a cooling medium circuit;
Fig. 3 is a graph showing the relationship between the thickness of the wiring layer shown in Fig. 1A and the coefficient of thermal expansion;
Fig. 4 is a schematic cross-sectional view illustrating a circuit board according to a second embodiment of the present invention;
Fig. 5A is schematic cross-sectional view illustrating a composite portion shown in Fig. 4.
Fig. 5B is a longitudinal cross-sectional view illustrating the wiring layer of Fig. 5A, having a three-layer structure;
Fig. 5C is a partially enlarged view of Fig. 5B;
Fig. 6 is a longitudinal cross-sectional view illustrating a wiring layer having a five-layer structure according to a modified embodiment of the present invention;
Fig. 7 is a graph showing the relationship between the thickness of the wiring layer shown in Fig. 4 and the coefficient of thermal expansion;
Fig. 8A is a diagrammatic plan view illustrating a circuit board according to a third embodiment of the present invention;
Fig. 8B is an enlarged cross-sectional view taken along line 8B-8B of Fig. 8A;
Fig. 8C is a cross-sectional view taken along line 8C-8C of Fig. 8A;
Fig. 9 is a cross-sectional view taken along line IX-IX in Fig. 8C;
Fig. 10 is a schematic cross-sectional view illustrating a method for manufacturing the circuit board of Fig. 8B;
Fig. 11A is a partial cross-sectional view illustrating a circuit board according to a fourth embodiment of the present invention;
Fig. 11B is a partially enlarged view of Fig. 11A;
Fig. 12A is a schematic partial cross-sectional view illustrating a circuit board according to a fifth embodiment of the present invention;
Fig. 12B is a partially enlarged view of Fig. 12A;
Fig. 13 is a schematic perspective view showing a method for manufacturing a metal composite material of Fig. 12B;
Fig. 14 is a schematic cross-sectional view illustrating a circuit board according to a sixth embodiment of the present invention;
Fig. 15A is a schematic cross-sectional view illustrating another method for manufacturing a cooling portion;
Fig. 15B is a schematic partial cross-section view illustrating a circuit board in which the cooling portion of Fig. 15A has been cast;
Fig. 16A is a diagrammatic plan view illustrating a circuit board according to another embodiment;
Fig. 16B is a schematic cross-sectional view illustrating a cooling portion according to another embodiment;
Fig. 17 is a cross-sectional view illustrating a modification;
Fig. 18A is a cross-sectional view illustrating a prior art printed wiring board; and
Fig. 18B is a plan view showing the shape of a heat medium channel of Fig. 18A.

### DETAILED DESCRIPTION OF THE PREFERRED EMBODIMENTS

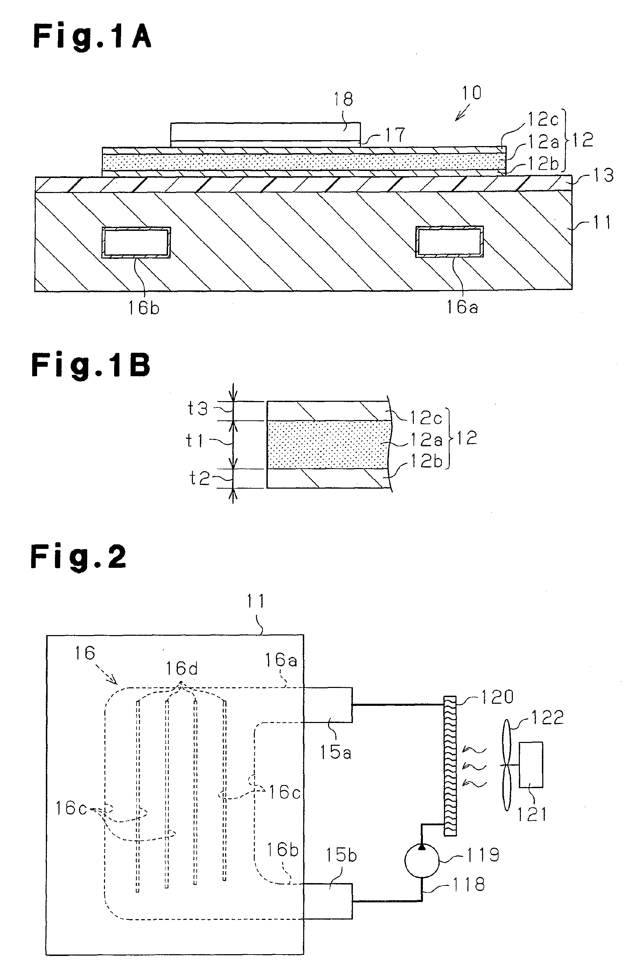

A first embodiment of the present invention will now be described with reference to Figs. 1A to 3.

As shown in Fig. 1A, a circuit board 10 includes a substrate 11 having a heat exhausting function. A wiring layer 12 is formed on the substrate 11 with an insulating layer 13 in between. "Heat exhausting function" refers to a function not only for radiating heat but also forcibly removing heat using, for example, a cooling medium. The coefficient of thermal expansion of the wiring layer 12 is made less than coefficients of thermal expansion of conductive traces made of metal typically used in circuit boards, such as copper and aluminum. On a surface of the wiring layer 12 that is opposite to the insulating layer 13, active components and passive components (not shown) are mounted with solder 17 in between. The active components include a semiconductor chip, or a semiconductor device 18, and the passive components include a chip resistor and a chip capacitor. The semiconductor device 18 is connected to circuit traces with aluminum wires (not shown). Although multiple semiconductor devices are mounted on the substrate 11 in reality, only one of them, or the semiconductor device 18, is representing all the semiconductor devices for purposes of illustration.

The substrate 11 has a cooling medium passage 16. The cooling medium passage 16 is made of an aluminum based metal. As shown in Fig. 2, a cooling medium flows through the cooling medium passage 16. The aluminum-based metal refers to aluminum or aluminum alloy. The cooling medium passage 16 has an inlet 16a, an outlet 16b, and channels 16c located between the inlet 16a and the outlet 16b. The channels 16c are defined by partitions 16d extending in parallel. Pipes 15a, 15b are molded in at the inlet 16a and the outlet 16b, respectively. The pipes 15a, 15b can be connected to a cooling medium circuit mounted on a vehicle. The thickness of the substrate 11 is about 10 mm.

The wiring layer 12 is formed by a metal composite material having a coefficient of thermal expansion less than coefficients of thermal expansion of the conductive traces of metal typically used in circuit boards. A metal composite material refers to a material that includes two or more types of metal or a material having metal and ceramics. Specifically, the wiring layer 12 includes an AlSiC portion 12a, or an AlSiC based composite material portion, and aluminum layers 12b, 12c sandwiching the AlSiC portion 12a. The AlSiC portion 12a is formed by mixing an inorganic binder with silicon carbide (SIC) powder, molding the mixture, baking the molded mixture, and injecting pressurized molten aluminum (Al) into the baked mixture in a mold. In the AlSiC portion 12a, the volume ratio of SiC and Al changes according to the particle size and the filling factor of the SiC powder. Accordingly, physical properties such as the coefficient of thermal expansion and the thermal conductivity vary.

Aluminum plates having desired thicknesses, or aluminum layers 12b, 12c, are provided to hold the AlSiC portion 12a having a desired thickness. Thereafter, the aluminum plates are heated to the melting temperature of aluminum, so that the aluminum plates are bonded to the AlSiC portion 12a in a limited state. Accordingly, the wiring layer 12 of a metal composite material is formed, which, as a whole, has a coefficient of thermal expansion greater than a silicon semiconductor chip and less than a coefficient of thermal expansion of copper.

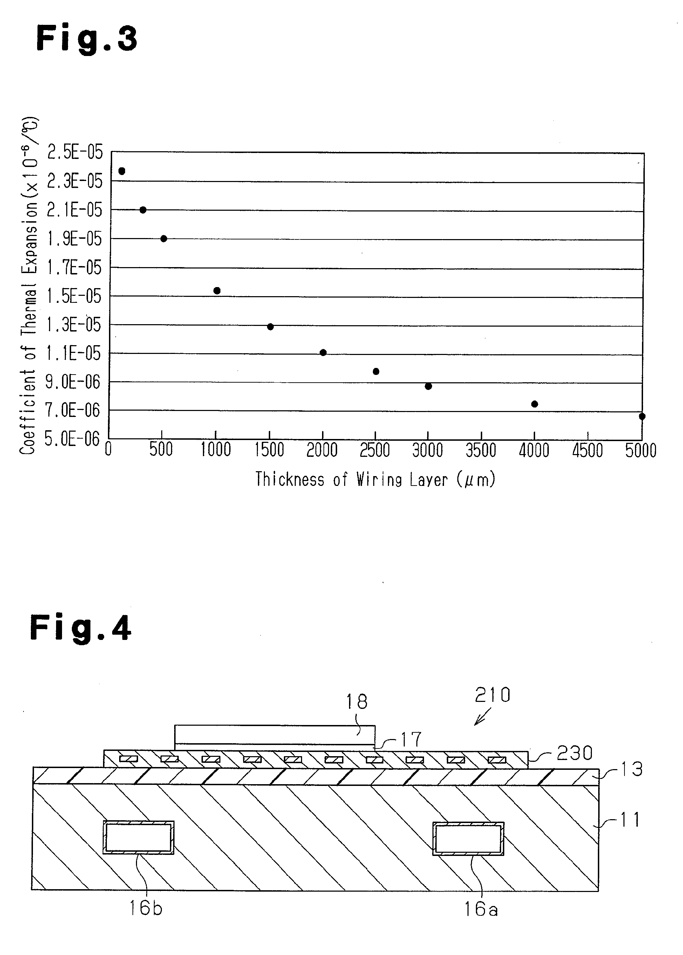

The coefficient of thermal expansion of the wiring layer 12 is variable in a wide range by changing the thickness as a whole or the thickness of any of the AlSiC portion 12a and the aluminum layers 12b, 12c. For example, the wiring layer 12 shown in Fig. 1B is set as a reference. In the wiring layer 12 of Fig. 1B, the thickness t1 of the AlSiC portion 12a is 3.0 mm, the thicknesses t2, t3 of the aluminum layers 12b, 12c are both 0.4 mm. If the thickness of the entire AlSiC portion 12a is changed without changing the ratio of the thicknesses t1, t2, t3, the relationship between the thickness of the wiring layer 12 and the coefficient of thermal expansion is as shown in Fig. 3. In a range of the thickness of the wiring layer 12 from 100 µm to 5000 µm, the coefficient of thermal expansion of the wiring layer 12 can be freely changed in the range from 6.5 × 10⁻⁶ to 2 5 × 10⁻⁶/°C. In the vertical axis of Fig. 3, the numerical suffix E-06 signifies the coefficient of thermal expansion × 10⁻⁶. The numerical suffix E-5 signifies the coefficient of thermal expansion × 10⁻⁵. The coefficient of thermal expansion of the silicon semiconductor chip is 2.6 × 10⁻⁶/°C, and the coefficient of thermal expansion of copper is 17.5 × 10⁻⁶/°C.

In the first embodiment, the wiring layer has a thickness of 2.5 mm, a coefficient of thermal expansion of 10.5 × 10⁻⁶/°C, and a thermal conductivity of 240 W/(mK). That is, the coefficient of thermal expansion of the wiring layer 12 is greater than the coefficient of thermal expansion of the silicon semiconductor chip, and less than the coefficient of thermal expansion of copper. The thermal conductivity of the wiring layer 12 is equal to or more than 30 W/(mK).

The insulating layer 13 is formed of a resin having an adhesion function. In the first embodiment, the insulating layer 13 is formed of an epoxy resin with which an aluminum filler is mixed to increase the thermal conductivity. The insulating layer 13, for example, has a thickness of 120 µm, a coefficient of thermal expansion of 58 × 10⁻⁶/°C, and a thermal conductivity of 5 W/(mK).

A method for manufacturing the circuit board 10, which is constructed as above, will hereafter be described. The substrate 11 is formed through casting of aluminum by using a core that corresponds to the cooling medium passage 16. An AlSiC plate and aluminum plates are laminated, and then pressurized and heated to form the wiring layer 12. The AlSiC plate becomes the AlSiC portion 12a, which has a shape corresponding to circuit traces and corresponds to a desired thickness. The aluminum plates become the aluminum layers 12b, 12c. The aluminum layer 12b, which faces the insulating layer 13, is anodized.

An uncured epoxy resin in which aluminum filler is dispersed is applied to the substrate 11. When the epoxy resin is partially cured, the wiring layer 12 is placed on the substrate 11 such that the aluminum layer 12b faces the epoxy resin layer. The wiring layer and the substrate 11 are then subjected to hot press, so that the epoxy resin layer is thermally cured. Since the aluminum layer 12b facing the insulating layer 13 is anodized, the wiring layer 12 is firmly bonded to the insulating layer 13 by the anchor effect. Next, the semiconductor device 18 and passive components (not shown) are mounted on the wiring layer 12 with the solder 17 in between. The circuit board 10 is thus completed.

An operation of the circuit board 10 thus constructed will now be described. Fig. 2 is a diagrammatic view showing the relationship between the substrate 11 and a cooling medium circuit 118. In Fig. 2, sections above the insulating layer 13 are omitted. As shown in Fig. 2, the circuit board 10 is used in a state where it is connected to the cooling medium circuit 118 through the pipes 15a, 15b. The cooling medium circuit 118 includes a pump 119 and a radiator 120. The radiator 120 has a fan 122 that is rotated by a motor 121, so that heat is effectively radiated from the radiator 120. For example, water is used as the cooling medium.

When the semiconductor device 18 mounted on the circuit board 10 is activated and heat is generated by the components on the circuit board 10, the heat is transferred to the substrate 11 via the solder 17, the wiring layer 12, and the insulating layer 13. The substrate 11 is forcibly cooled by the cooling medium flowing through the cooling medium passage 16. Accordingly, the temperature gradient of a transfer pathway of heat from the semiconductor device 18 to the substrate 11 is increased. Thus, heat generated by the semiconductor device 18 is effectively removed from the substrate 11.

The thermal conductivity of the insulating layer 13 is one digit greater than a thermal conductivity of the grease. Therefore, compared to the structure in which a heat sink is fixed to a cooling portion that has a high cooling performance with grease in between as in the prior art, the circuit board 10 has a smaller thermal resistance. Thus, when a large current is supplied to the semiconductor device 18 and a great amount is heat is generated, the heat is effectively removed. Accordingly, the temperature of the semiconductor device 18 is prevented from being excessively increased. This allows the semiconductor device 18 to receive a large current.

The components mounted on the wiring layer 12 include a chip resistor and a chip capacitor in addition to the semiconductor device 18. The coefficient of thermal expansion of the silicon semiconductor chip is 2.6 × 10⁻⁶/°C, the coefficient of thermal expansion of the chip resistor is about 7 × 10⁻⁶/°C, and the coefficient of thermal expansion of the chip capacitor is about 10 × 10⁻⁶/°C. In contrast, the coefficient of the wiring layer 12 is 10.5 × 10⁻⁶/°C. Therefore, compared to the case where a wiring layer is formed of metal such as copper or aluminum, the difference of the coefficient of thermal expansion between the wiring layer 12 and the components mounted on the semiconductor device 18 according to the first embodiment is less than the difference of the coefficient of thermal expansion between a conductive traces made of metal, which is typically used in circuit boards, and mounted components. Therefore, the stress applied to the joints of the solder 17 in cooling-heating cycles is reduced. This extends the life in cooling-heating cycles and improves the reliability of the soldered joints.

When the circuit board 10 is used on a vehicle, for example, when the circuit board 10 is used in a vehicle inverter device and accommodated in an engine compartment, heat generated by the semiconductor device 18 needs to be effectively removed. In the circuit board 10 according to the first embodiment, the cooling medium flowing through the cooling medium passage 16 effectively removes heat generated by the semiconductor device 18. The vehicle has a cooling medium circuit for cooling the engine. Thus, if the cooling medium passage 16 is connected to the cooling medium circuit of the vehicle via the pipes 15a, 15b, no component such as a pump for the cooling medium that cools the circuit board 10 is required.

The circuit board 10 according to the first embodiment provides the following advantages.
(1) The wiring layer 12 on the substrate 11, which has a heat exhausting function, with the insulating layer 13 in between, and the wiring layer 12 is formed by a metal composite material having a coefficient of thermal expansion less than the coefficients of thermal expansion of metal conductive traces typically used on a circuit board. Therefore, heat generated by the semiconductor device 18 and the electronic components mounted on the wiring layer 12 with the solder 17 in between is efficiently removed without providing a heat sink or a heat spreader. This allows the semiconductor device 18 mounted on the substrate 11 to receive a large current and facilitates the miniaturization of the module. The coefficient of thermal expansion of the wiring layer 12 as a whole is less than the coefficients of thermal expansion of the conductive traces of metal typically used in circuit boards. Therefore, the difference of the coefficient of thermal expansion between the semiconductor device 18 and the wiring layer 12 is less than the difference of the coefficient of thermal expansion between the semiconductor device 18 and the metal conductive traces. This extends the life in cooling-heating cycles and improves the reliability of the soldered joints.
(2) The coefficient of thermal expansion of the wiring layer 12 is greater than the coefficient of thermal expansion of the silicon semiconductor chip, and less than the coefficient of thermal expansion of copper. Therefore, it is easy to manufacture the wiring layer 12 such that the difference of the coefficient of thermal expansion between the wiring layer 12 and semiconductor device 18 is less than the difference of the coefficient of thermal expansion between metal conductive traces typically used on circuit boards and the semiconductor device 18.
(3) The thermal conductivity of the wiring layer 12, which is 240 W/(mK), is greater than a thermal conductivity of solder, which is 30 W/(mK). Therefore, the wiring layer 12 does not prevent heat generated by the semiconductor device 18 mounted on the wiring layer 12 from being transferred to the substrate 11.
(4) The wiring layer 12 includes the AlSiC portion 12a and the aluminum layers 12b, 12c sandwiching the AlSiC portion 12a. Therefore, it is easy to set the coefficient of thermal expansion and the thermal conductivity of the wiring layer 12 to appropriate values corresponding to the semiconductor device 18 and the electronic components mounted on the wiring layer 12.
(5) The substrate 11 has the cooling medium passage 16, through which cooling medium flows. Therefore, the cooling medium flowing through the cooling medium passage 16 removes heat from the substrate 11, so that the heat of the wiring layer 12 is efficiently transferred to the substrate 11. This improves the cooling efficiency of the semiconductor device 18 and the electronic components mounted on the wiring layer 12.
(6) Water is used as the cooling medium. This permits heat of the substrate 11 to be efficiently removed with an inexpensive configuration.
(7) The cooling medium passage 16 is configured to be connectable with the cooling medium circuit 118 mounted on the vehicle. When the circuit board 10 is used on a vehicle, for example, when the circuit board 10 is used in a vehicle inverter device and accommodated in an engine compartment, heat generated by the semiconductor device 18 needs to be effectively removed. In this case, the circuit board 10 is used in a state where the cooling medium flowing in the cooling medium circuit 118 mounted on the vehicle flows through the cooling medium passage 16 of the substrate 11. Therefore, no dedicated pump for circulating cooling medium is needed for the circuit board 10.
(8) The insulating layer 13 is formed of a resin having an adhesion function. Therefore, compared to the case where ceramics is used for the insulating layer 13, the wiring layer 12 is easily bonded to the substrate 11.

A second embodiment of the present invention will now be described with reference to Figs. 2, and 4 to 7. This embodiment is the same as the first embodiment except for the configuration of the wiring layer. Thus, like or the same reference numerals are given to those components that are like or the same as the corresponding components of the first embodiment.

As shown in Fig. 4, a circuit board 210 of the second embodiment includes a substrate 11. A wiring layer 230 is provided on the substrate 11 with an insulating layer 13 in between. The coefficient of thermal expansion of the wiring layer 230 is made less than the coefficients of thermal expansion of conductive traces made of metal typically used in circuit boards, such as copper and aluminum. On a surface of the wiring layer 230 that is opposite to the insulating layer 13, active components such as the semiconductor device 18 and passive components such as a chip resistor and a chip capacitor are mounted with solder 17 in between. The semiconductor device 18 is connected to circuit traces with aluminum wires (not shown). As shown in Fig. 2, the substrate 11 has a cooling medium passage 16 similar to the first embodiment. The cooling medium passage 16 has an inlet 16a an outlet 16b. Pipes 15a, 15b are molded at the inlet 16a and the outlet 16b, respectively. The pipes 15a, 15b can be connected to the cooling medium circuit 118 mounted on a vehicle.

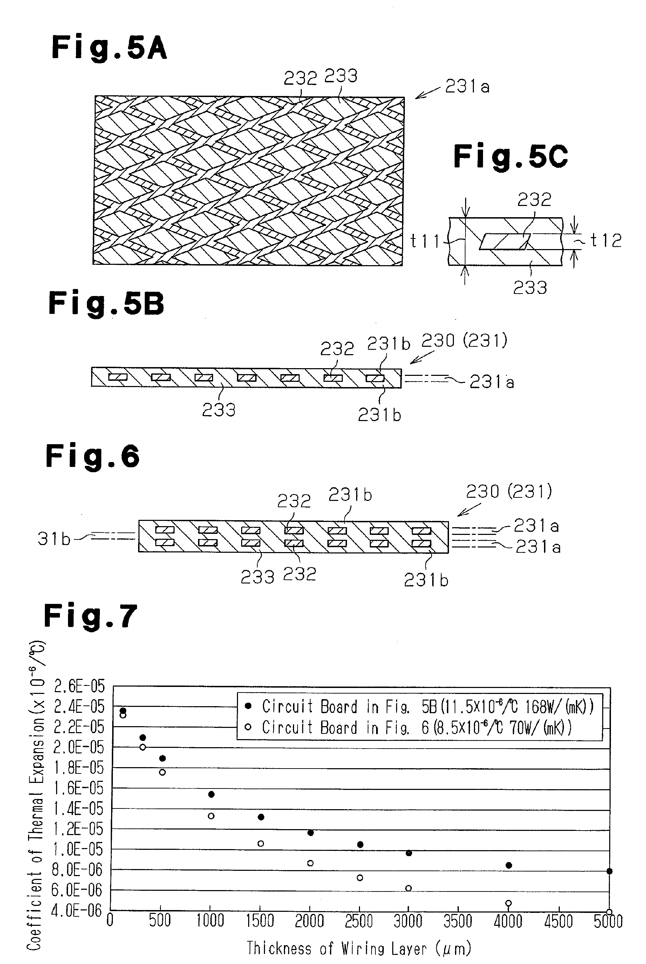

As shown in Figs. 5A and 5B, the wiring layer 230 is formed by a composite material 231, which includes a composite portion 231a of copper and invar, and copper layers 231b sandwiching the composite portion 231a. The composite material 231 is formed by sandwiching an expanded metal sheet 232 with a pair of copper plates 233 and then rolling and joining the sheet 232 with the plates 133. More specifically, the copper plates 233 and the expanded metal sheet 232, which is arranged between the copper plates 233, are heated and extended by rollers. As a result, the copper plates 133 and the expanded metal sheet 232 are integrated into the composite material 231. By combining the expanded metal sheet 232 and the copper plates 233, the composite material 231 is formed of the expanded metal sheet 232 and a matrix metal, or copper, surrounding the expanded metal sheet 232. Accordingly, the wiring layer 230 of a metal composite material is formed, which, as a whole, has a coefficient of thermal expansion greater than a silicon semiconductor chip and less than the coefficient of thermal expansion of copper.

Invar is an alloy containing 36% of weight of nickel (Ni). The remaining portion of Invar is substantially iron (Fe). The composite portion of copper and invar does not refer to a structure in which copper layers and invar layers are simply laminated, but to a structure in which divided copper areas and continuous invar areas exist in the same layer. Therefore, the coefficient of thermal expansion and the thermal conductivity of the composite portion of copper and invar change depending on the area ratio of the copper areas and the invar areas.

When the thickness of the composite material 231 and the thickness of the expanded metal sheet 232 after rolling and joining are referred to as t11, t12, respectively, as shown in Fig. 5C, the thickness of the expanded metal sheet 232, and the thickness and the reduction ratio of each copper plate prior to rolling and joining are determined such that (t12)/(t11) is between 0.2 and 0.8, inclusive.

The configuration of the composite material 231 is not limited to the configuration in which a single layer of the composite portion 231a is formed, but may be a configuration that two layers of the composite portions 231a are formed as shown in Fig. 6. In the case of the composite material 231 having two layers of the composite portions 231a, the composite material 231 is formed by alternately laminating three copper plates 233 and two expanded metal sheets 232 and then rolling and joining the expanded metal sheets 232 with the copper plates 233.

The coefficient of thermal expansion of the wiring layer 230 is variable in a wide range by changing the thickness as a whole or the thickness of the composite portion 231a and the copper layers 231b. Fig. 7 is graph showing the case in which the thickness, Young's modulus, and coefficient of thermal expansion of an aluminum heat sink, or the substrate 11, are set to 4 mm, 77 GPa, and 25 × 10⁻⁶/°C, respectively. The thickness, the Young's modulus, and the coefficient of the insulating resin, or the insulating layer 13, are set to 0.12 mm, 530 MPa, and 25 × 10⁻⁶/°C, respectively. The Young's modulus of the wiring layer 230 is set to 110 GPa, and the coefficient of thermal expansion of the wiring layer 230 is set to 11.5 × 10⁻⁶/°C and 8.5 × 10⁻⁶/°C. Fig. 7 is a graph plotting values of the coefficient of thermal expansion of the upper surface of the wiring layer 230, or bonded interface between the wiring layer 230 and the solder 17, when the thickness of the wiring layer 230 is varied from 100 to 5000 µm.

In a range of the thickness of the wiring layer 230 of a three-layer structure shown in Fig. 5B from 100 µm to 5000 µm, the coefficient of thermal expansion of the wiring layer 230 can be freely changed in the range from 8.0 × 10⁻⁶ to 23.5 × 10⁻⁶/°C. When the thickness of the wiring layer 230 is set to 2000 µm, the coefficient of thermal expansion and the thermal conductivity of the wiring layer 230 are 11.5 × 10⁻⁶/°C and 168 W/(mK), respectively. In a range of the thickness of the wiring layer 230 of a five-layer structure shown in Fig. 6 from 100 µm to 5000 µm, the coefficient of thermal expansion of the wiring layer 230 can be freely changed in the range from 4.0 × 10⁻⁶ to 23.0 × 10⁻⁶/°C. When the thickness of the wiring layer 230 is set to 2000 µm, the coefficient of thermal expansion and the thermal conductivity of the wiring layer 230 are 8.5 × 10⁻⁶/°C and 70 W/(mK), respectively.

The method for manufacturing the circuit board 210 is different from the manufacturing method of the first embodiment in that the wiring layer 12 is replaced by the wiring layer 230. Further, to increase the boding strength between the wiring layer 230 and the insulating layer 13, the copper layers 231b are subjected to black oxidation instead of anodizing of the aluminum layer 12b as in the first embodiment. The wiring layer 230 is thus firmly bonded to the insulating layer 13 by the anchor effect. The second embodiment is different from the first embodiment in that, after formed on the substrate 11 with the insulating layer 13 in between, the wiring layer 230 is etched to form a predetermined circuit pattern.

The circuit board 210 constructed as shown above is used in the same manner as the circuit board 10 according to the first embodiment. In addition to the same advantages as the advantages (1), (2), (5) to (8) of the first embodiment, the circuit board 210 of the second embodiment has the following advantages.
(9) The thermal conductivity of the wiring layer 230 is greater than the thermal conductivity of solder 17, which is 30 W/(mK). Therefore, the wiring layer 230 does not prevent heat generated by the semiconductor device 18 mounted on the wiring layer 230 from being transferred to the substrate 11. That is, the wiring layer 230 is not a bottleneck in the heat transfer.
(10) The wiring layer 230 includes the composite portion 231a and the copper layers 231b sandwiching the composite portion 231a. Therefore, it is easy to set the coefficient of thermal expansion and the thermal conductivity of the wiring layer 230 to appropriate values corresponding to the semiconductor device 18 and the electronic components mounted on the wiring layer 230.
(11) Since the wiring layer 230 is a metal composite material, a circuit pattern can be formed thereon by etching. The formation of a circuit pattern is more facilitated in the second embodiment than in the first embodiment.

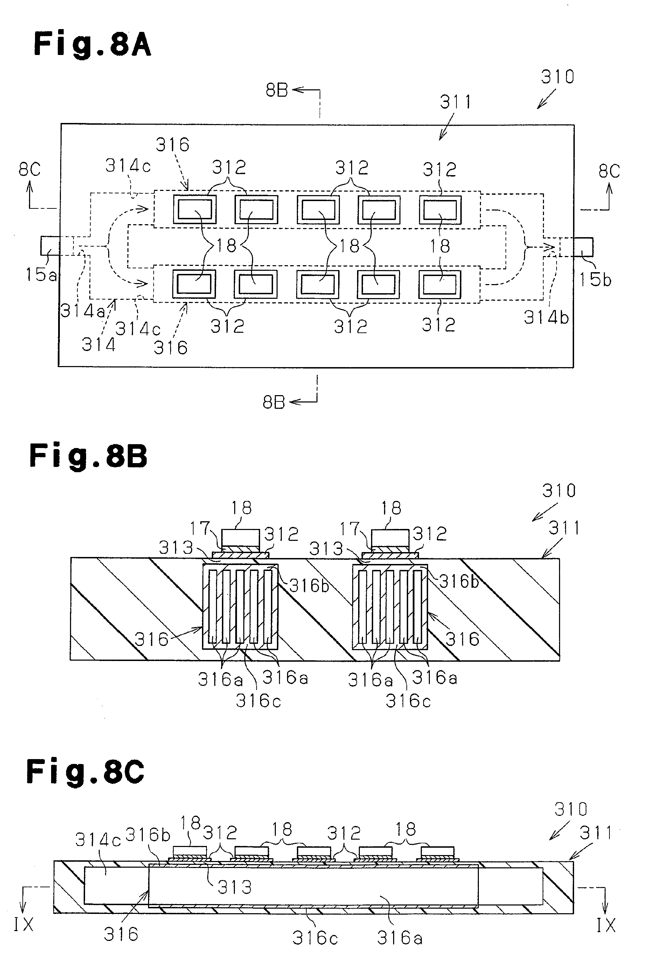

A third embodiment of the present invention will now be described with reference to Figs. 8A to 10.

As shown in Figs. 8A to 8C, a circuit board 310 includes a substrate 311 and wiring layers 312. Each wiring layer 312 is formed on the substrate 311 with an insulating layer 313 in between. The substrate 311 is formed of a resin, which is an insulating resin in this embodiment. That is, the substrate 311 has a resin area formed of resin. The substrate 311 has a cooling medium passage 314. The cooling medium passage 314 has a rectangular cross section, and an inlet 314a and an outlet 314b. The passage 314 is branched into two channels 314c from the inlet 314a. The two channels 314c converge into one channel connected to the outlet 314b. Pipes 15a, 15b are molded in at the inlet 314a and the outlet 314b, respectively. The pipes 15a, 15b can be connected to a cooling medium circuit 118 mounted on a vehicle as shown in Fig 2.

In each of the channels 314c, a metal cooling portion 316 is embedded to form a part of the cooling medium passage 314. In this embodiment, the cooling portions 316 are made of an aluminum-based metal. The aluminum-based metal refers to aluminum or an aluminum alloy. Each cooling portion 316 includes a plurality of cooling medium channels 316a extending parallel to the channel 314c. The cross-sectional area of each cooling medium channel 316a is less than the cross-sectional area of each channel 314c. A flat portion 316b is formed at a portion of each cooling portion 316 that corresponds to the wiring layer 312. A flat portion 316c is formed at a portion of each cooling portion 316 that is opposite to the wiring layer 312.

The insulating resin forming the substrate 311 has a smaller coefficient of thermal expansion than the coefficient of thermal expansion of the cooling portions 316. By mixing filler such as ceramics particles or fibers in a resin, the coefficient of thermal expansion of the insulating resin is adjusted to be less than the coefficient of thermal expansion of the cooling portion 316, that is, the coefficient of thermal expansion of an aluminum based metal in this embodiment. The material of the filler may be glass, alumina, silicon nitride, or boron nitride.

The wiring layers 312 are provided at a plurality of positions on the flat portion 316b of each cooling portion 316. The cooling medium channels 316a extend in a direction of arrangement of the wiring layers 312, that is, along the left-right direction in Fig. 8A. The wiring layer 312 is made of a metal typically used in circuit boards. In this embodiment, the wiring layers 312 are made of copper. On the surface of each wiring layer 312 opposite to the insulating layer 313, a semiconductor device 18 serving as a silicon semiconductor chip is mounted with solder 17 in between. Each semiconductor device 18 is connected to corresponding wiring layer 312 with aluminum wires (not shown).

To increase the thermal conductivity of the insulating layer 313, ceramics filer having a greater insulating property than resin is mixed in the insulating layer 313. When mounting the semiconductor device 18 on each wiring layer 312 with the solder 17 in between, the insulating layer 313 needs to be prevented from being melted by the heat for melting the solder 17. Thus, when a thermoplastic resin is used for the insulating layer 313, a thermoplastic resin the melting point of which is 100°C or higher is used. For example, polyamide or polyester is used. In this embodiment, the resin in which the cooling portions 316 are embedded and the insulating layer 313 are formed of the same insulating resin.

The thickness of the substrate 311 is about 10 mm. If the thickness is insufficient, the pressure capacity of the insulating layer 313 will be degraded. If the thickness is excessive, the heat conduction/heat transfer performance will be degraded. Thus, the thickness of the insulating layer 313 is 10 to 300 µm, and preferably 20 to 100 µm. The wiring layers 312 are made of copper, the thermal conductivity of which is sufficiently greater than the thermal conductivity of the solder. Therefore, thickness of each wiring layer 312 is appropriately determined depending on the magnitude of the maximum current flowing through the wiring layer 312.

Each of the Figs. 8A to 8C schematically shows the structure of the circuit board 310. For the illustrative purposes, some of the measurements are exaggerated. That is, the ratios of the widths, lengths, and thicknesses in the drawings are different from the actual ratios. The same applies to other embodiments.

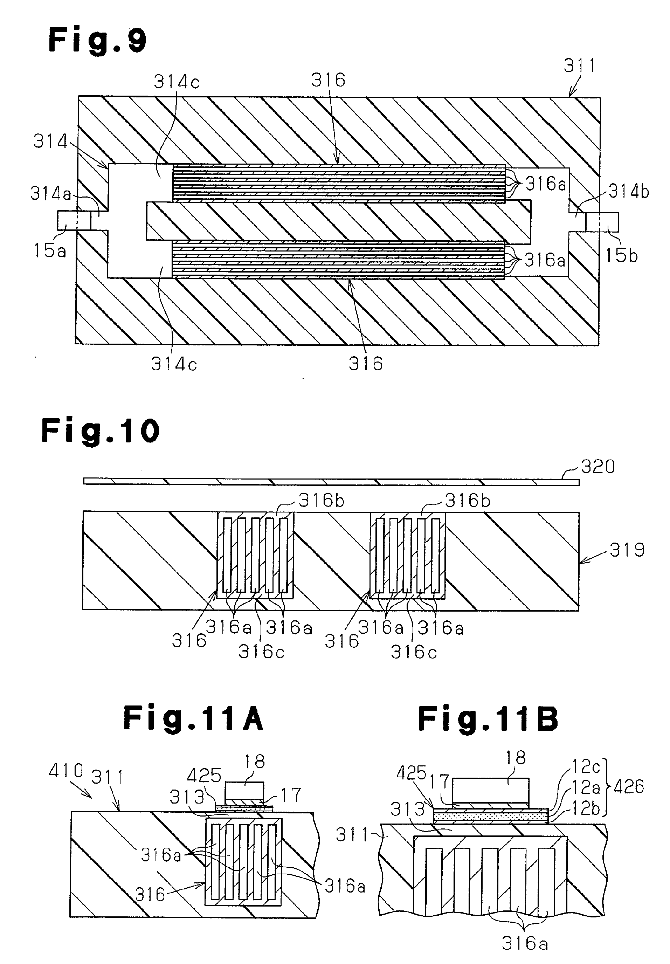

A method for manufacturing the circuit board 310, which is constructed as above, will hereafter be described. The cooling portions 316 are formed, for example, through the extrusion molding. The outer surface of each cooling portion 316 is then is anodized. The cooling portion 316, the outer surface of which has been anodized, is placed in a predetermined position inside a mold and is subjected to the injection molding or the transfer molding. Accordingly, a molded part 319 is formed in which the cooling portions 316 are embedded in the resin with the flat portions 316b exposed as shown in Fig. 10. In the case where a thermoplastic resin is used for the insulating layer 313, the injection molding is performed, and in the case where a thermosetting resin is used, the transfer molding is performed. Since the outer surface of each cooling portion 316 has been anodized, the resin is firmly bonded to the outer surface of the cooling portions 316 by the anchor effect.

Subsequently, the insulating layer 313 is formed on the exposed parts of the flat portions 316b of the molded part 319. Specifically, a sheet 320 is arranged as shown in Fig. 10 to face the flat portions 316b. The sheet 320 is bonded to the flat portions 316b by a hot press. If the sheet 320 is made of a thermoplastic resin, the sheet 320 is bonded to the flat portions 316b simply by a hot press. If the sheet 320 is made of a thermosetting resin, the sheet 320 is prepared in a partially cured state and bonded to the flat portions 316b by a hot press. Accordingly, the substrate 311 is completed in which the metal cooling portions 316 each having the cooling medium channels 316a are embedded in the insulating resin.

Then, the wiring layers 312 are formed on predetermined positions on the sheet 320 functioning as the insulating layer 313. When forming the wiring layers 312, a method for forming MID (Molded Interconnect Device) is used. For example, a method in which a copper plate (copper foil) is heated and pressed (hot stamping), a method in which a copper plate (copper foil) is bonded by a punching press (IVONDING method), or method in which the wiring layer is formed by plating. In this embodiment, the copper plates each formed as the shape of the wiring layer 312 is bonded to the sheet 320 by a hot press. At least a surface of the copper plate that faces the sheet 320 is subjected to black oxidation in advance. Since the copper plate has been subjected to black oxidation, the wiring layers 312 are firmly bonded to the sheet 320, or the insulating layer 13, by the anchor effect. The circuit board 310 on which the semiconductor devices 18 are yet to be mounted is completed.

Next, the semiconductor devices 18 and non-illustrated passive components (for example, chip resistors and chip capacitors) are mounted on the wiring layers 312 with the solder 17 in between. The circuit board 10 is thus completed.

An operation of the circuit board 310 thus constructed will now be described. The circuit board 310 is used in a state where it is connected to the cooling medium circuit 118 shown in Fig. 2 through the pipes 15a, 15b. The cooling medium circuit 118 includes a pump 119 and a radiator 120. The radiator 120 has a fan 122 that is rotated by a motor 121, so that heat is effectively radiated from the radiator 120. For example, water is used as the cooling medium.

When the semiconductor devices 18 mounted on the circuit board 310 are activated and heat is generated by the components on the circuit board 310, the heat is transferred to the cooling portions 316 via the solder 17, the wiring layers 312, and the insulating layer 313. The heat transferred to the cooling portions 316 is then transferred to cooling medium flowing through the cooling medium channels 316a. The heat is then carried away by the cooling medium. That is, the substrate 311 is forcibly cooled by the cooling medium flowing through the cooling medium channel 316a. Accordingly, the temperature gradient of a transfer pathway of heat from the semiconductor device 18 to the substrate 311 is increased. Thus, heat generated by the semiconductor device 18 is effectively removed through the substrate 311.

The wiring layers 312 are each provided on the flat portion 316b forming a part of the corresponding cooling portion 316 with the insulating layer 313 in between. The distance between each wiring layer 312 and the corresponding flat portion 316b is substantially constant. Therefore, compared to the case where the flat portions 316b are not provided and the distance between each wiring layer 312 and the corresponding cooling portion 316 varies depending on the position, heat is reliably transferred from the wiring layer 312 to the cooling portion 316. Further, the thermal expansion of the metal cooling portions 316 is suppressed by the insulating resin in which the cooling portions 316 are embedded. This extends the life in cooling-heating cycles. Also, the reliability of the soldered joints when the semiconductor devices 18 are mounted on the wiring layers 312 with the solder 17 in between is improved.

In the case where the wiring layers 312 are provided on the substrate 311 and semiconductor devices 318 are mounted on the wiring layers 312, all the semiconductor devices 18 do not always operate simultaneously. When each semiconductor device 18 generates heat, the amount of the generated heat is the greatest in a center of the semiconductor device 18. The heat is transferred to the solder 17 and the wiring layer 312, and then transferred to the corresponding cooling portion 316 through the wiring layer 312 and the insulating layer 313. The thermal conductivity of the insulating layers 313 is one digit smaller than those of the wiring layers 312 and the cooling portions 316. In the third embodiment, a number of the wiring layers 312 are provided on each portion 316b. Therefore, the heat of the wiring layer 312 on which a heat generating one of the semiconductor devices 18 is mounted is transferred to a portion corresponding to another wiring layers 312 via the flat portion 316b, and cooled by the cooling portion 316. Therefore, the radiation performance (cooling performance) is improved.

The thermal conductivity of the insulating layer 313 is one digit greater than the thermal conductivity of the grease. Therefore, compared to the structure in which a heat sink is fixed to a cooling portion that has a high cooling performance with grease in between, the thermal resistance is reduced in the third embodiment. Thus, when a large current is supplied to the semiconductor device 18 and a great amount is heat is generated, the heat is effectively removed. Accordingly, the temperature of the semiconductor device 18 is prevented from being excessively increased. This allows the semiconductor device 18 to receive a large current.

When the circuit board 310 is used on a vehicle, for example, when the circuit board 310 forms a part of a vehicle inverter device and is accommodated in an engine compartment, heat generated by the semiconductor device 18 needs to be effectively removed. In the circuit board 310 according to the third embodiment, the cooling medium flowing through the cooling medium channel 316a effectively removes heat generated by the semiconductor device 18. In the case where the circuit board 310 is mounted on a vehicle having the cooling medium circuit 118 for cooling the engine, if cooling medium passage 314 is connected to the cooling medium circuit 118 via the pipes 15a, 15b, no component such as a pump dedicated for the cooling medium that cools the circuit board 310 is required.

The third embodiment provides the following advantages.
(21) The circuit board 310 includes the substrate 311 in which the metal cooling portions 316, each having the cooling medium channels 316a, are embedded with resin. The wiring layers 312 are mounted on the substrate 311 with the insulating layer 313 in between. Each wiring layer 312 is capable of mounting a silicon semiconductor chip. A flat portion 316b is formed at a portion of each cooling portion 316 that corresponds to the wiring layer 312. Therefore, the distance between each wiring layer 312 and the corresponding flat portion 316b is easily made constant. Therefore, compared to the case where the distance between each wiring layer 312 and the corresponding cooling portion 316 varies depending on the position, heat is reliably transferred from the wiring layer 312 to the cooling portion 316 in the circuit board 310 in which such distance is made constant or substantially constant.

A resin having a coefficient of thermal expansion that is smaller than the coefficient of thermal expansion of the cooling portions 316 is used as the resin for embedding the cooling portions 316. Therefore, the thermal expansion of the metal cooling portions 316 is suppressed by the resin in which the cooling portions 316 are embedded. This extends the life in cooling-heating cycles. Also, the reliability of the soldered joints when the semiconductor devices (silicon semiconductor chips) 18 are mounted on the wiring layers 312 with the solder 17 in between is improved.
(22) The resin in which the cooling portions 316 are embedded and the insulating layer 313 are formed of the same insulating resin. Therefore, only one type of resin is required for forming the insulating layer 313. Thus, for example, compared to a case where the insulating layer 313 is formed of a resin different from the insulating resin in which the cooling portions 316 are embedded, the preparation and storage of materials are facilitated.
(23) The wiring layers 312 are commonly provided at a plurality of sections on each flat portion 316b. Therefore, compared to a case where the flat portions 316b independently provided for each of the wiring layers 312, each cooling portion 316 effectively performs cooling. Therefore, the radiation performance (cooling performance) is improved.
(24) The cooling medium channels 316a extend in a direction of arrangement of the sections of the wiring layers 312. Thus, the cooling medium flowing through the cooling medium channels 316a entirely contribute to cooling. For example, in the case where a plurality of the cooling medium channels 316a are provided, and a plurality of the wiring layers 312 each corresponds to one of the passages, if some of a plurality of the semiconductor devices 18 on the wiring layers 312 generate heat, cooling medium flowing through some of the cooling medium channels 316a only slightly contributes to cooling. However, this does not occur in the third embodiment.
(25) Since the cooling portions 316 are made of an aluminum based metal, the circuit board 310 is light, and easily and inexpensively manufactured.
(26) The thermal conductivity of the copper wiring layer 312 is equal to or greater than ten times the thermal conductivity of the solder (30 W/(mK)). Therefore, the wiring layer 312 does not prevent heat generated by the semiconductor device 18 mounted on the wiring layer 312 from being transferred to the substrate 311.
(27) Water is used as the cooling medium. This permits heat of the substrate 311 to be efficiently removed with an inexpensive configuration.
(28) The cooling medium passage 314 is configured to be connectable with the cooling medium circuit 118 mounted on the vehicle. Therefore, no dedicated pump for circulating cooling medium is needed for the circuit board 310.
(29) Each cooling portion 316 is embedded in a state contacting the insulating resin not only in the peripheral surfaces extending along the longitudinal direction, but also in a part of end surfaces perpendicular to the longitudinal direction. Therefore, compared to the structure in which the end surfaces do not contact the insulating resin, thermal expansion of the cooling portion 316 is further effectively suppressed.
(30) When manufacturing the substrate 311, the cooling portions 316 are placed in a mold. Then, by the injection molding or the transfer molding, the molded part 319 having no portion corresponding to the insulating layer 313 is produced. Thereafter, by bonding the sheet 320 to the molded part 319, the portion corresponding to the insulating layer 313 is formed. Therefore, even if the portion corresponding to the insulating layer 313 has a thickness as small as several tens of micrometers, the insulating layer 313 having a desired thickness is reliably and easily formed.
(31) Since the wiring layers 312 are made of copper, a circuit pattern can be formed by etching. That is, a circuit pattern is easily formed. For example, instead of the resin sheet 320, a resin sheet having a copper layer laminated on one side may be used. In this case, after bonding the resin sheet with a copper layer to the insulating layer 313, the copper layer is etched to form the wiring layers 312 having predetermined shapes.

A fourth embodiment of the present invention will now be described with reference to Figs. 11A and 11B. The fourth embodiment is the same as the third embodiment except for the structure of the wiring layers 312. Therefore, like or the same reference numerals are given to those components that are like or the same as the corresponding components of the third embodiment.

As shown in Fig. 11A, a circuit board 410 includes a substrate 311. A wiring layer 425 is formed on the substrate 311 with an insulating layer 313 in between. In the fourth embodiment, the wiring layer 425 is made of a metal composite material that has a coefficient of thermal expansion greater than the coefficient of thermal expansion of silicon semiconductor chips and smaller than the coefficient of thermal expansion of copper. As the metal composite material, an AlSiC based composite material is used.

As shown in Fig. 11B, an AlSiC based composite material 426 includes an AlSiC portion 12a and the aluminum layers 12b, 12c sandwiching the AlSiC portion 12a.

The coefficient of thermal expansion of the wiring layer 425 is variable in a wide range by changing the thickness as a whole or the thickness of any of the AlSiC portion 12a and the aluminum layers 12b, 12c. For example, the ratio of the thickness t1 of the AlSiC portion 12a and the thickness t2 of the aluminum layers 12b, 12c, or the ratio t1/t2 is set to 3/0.4, and the thickness of the entire wiring layer 425 is set to 2. 5 mm. In this case, the coefficient of thermal expansion and the thermal conductivity of the wiring layer 425 are 10.5 × 10⁻⁶/°C and 240 W/(mK).

The circuit board 410 constructed as shown above is used in the same manner as the circuit board 310 according to the third embodiment. The circuit board 310 according to the fourth embodiment further provides the following advantages.
(32) The thermal conductivity of the wiring layer 425 is equal to or greater than several times the thermal conductivity of the solder (30 W/(mK)). Therefore, the wiring layer 425 does not prevent heat generated by the semiconductor device 18 mounted on the wiring layer 425 from being transferred to the substrate 311.
(33) The wiring layer 425 is made of a metal composite material that has a coefficient of thermal expansion greater than the coefficient of thermal expansion of silicon semiconductor chips and smaller than the coefficient of thermal expansion of copper. Thus, the difference of the coefficients of thermal expansion between the semiconductor device 18 and the wiring layer 425 is less than the difference of the coefficients of thermal expansion of the case where the wiring layer 425 is made of, for example, copper or aluminum. This further extends the life in cooling-heating cycles and improves the reliability of the soldered joints.
(34) The metal composite material includes the AlSiC portion 12a and the aluminum layers 12b, 12c sandwiching the AlSiC portion 12a. Therefore, for example, the ratio of thickness between the AlSiC portion 12a and the thickness of the aluminum layers 12b, 12c is changed. Therefore, it is easy to set the coefficient of thermal expansion and the thermal conductivity of the wiring layer 425 to appropriate values corresponding to the semiconductor device 18 and the electronic components mounted on the wiring layer 425.

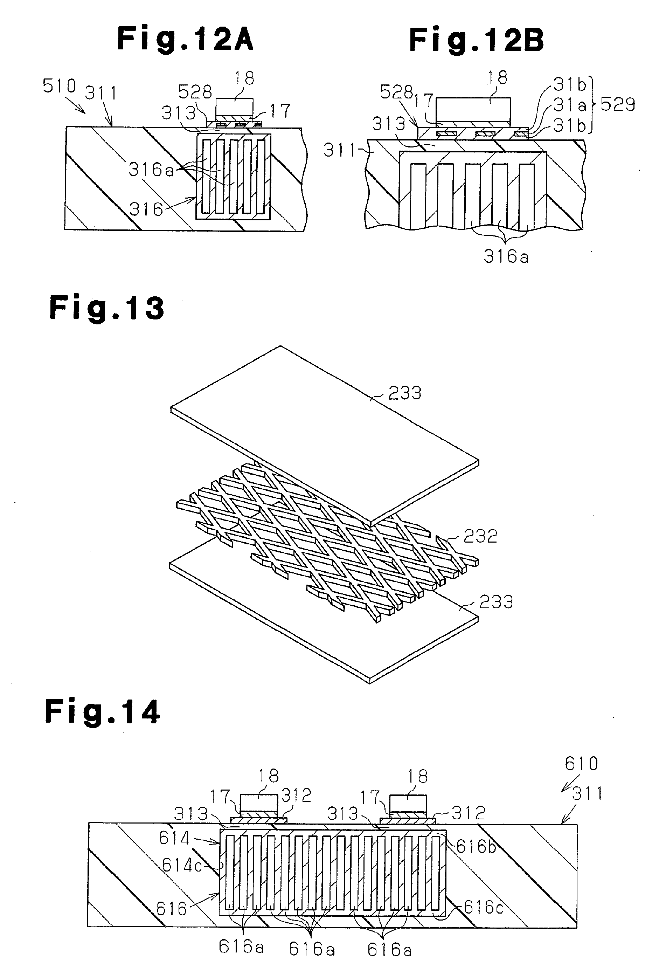

A fifth embodiment of the present invention will now be described with reference to Figs. 12A, 12B, and 13. The fifth embodiment is the same as the fourth embodiment in that a wiring layer 528 is made of a metal composite material, but different from the fourth embodiment in the structure of the metal composite material. The features of the fifth embodiment are the same as those of the third and fourth embodiments.

As shown in Fig. 12A, a circuit board 510 includes a substrate 311. A wiring layer 528 is formed on the substrate 311 with an insulating layer 313 in between. The wiring layer 528 is made of a metal composite material having a coefficient of thermal expansion greater than the coefficient of thermal expansion of silicon semiconductor chips. As shown in Fig. 12B, the metal composite material 529 forming the wiring layer 528 includes a composite portion 231a of copper and invar, and copper layers 231b sandwiching the composite portion 231a.

As shown in Fig. 13, the metal composite material 529 is formed by sandwiching an expanded metal sheet 232 with a pair of copper plates 233 and then rolling and joining the sheet 232 with the plates 233. Accordingly, the metal composite material 529 is formed, which, as a whole, has a coefficient of thermal expansion greater than a silicon semiconductor chip and less than the coefficient of thermal expansion of copper. The ratio (t12)/(t11) is set in a range between 0.2 and 0.8, inclusive. The metal composite material 529 may be formed to conform to the shape of the wiring layer 528. Alternatively, a plate larger than the wiring layer 528 may be first formed, and the plate may be cut into a predetermined shape.

As shown in Fig. 6, the composite portion 231a of the metal composite material 529 may have a two-layer structure. The coefficient of thermal expansion of the wiring layer 528 is variable in a wide range by changing the thickness as a whole or the thickness of the composite portion 231a and the copper layers 231b. For example, when the thickness of the wiring layer 528 is set to 2000 µm, the coefficient of thermal expansion and the thermal conductivity of the wiring layer 528 are 11.5 × 10⁻⁶/°C and 168 W/(mK), respectively.

The circuit board 510 constructed as shown above is used in the same manner as the circuit boards 310, 410 according to the third and fourth embodiments. The circuit board 510 according to the fifth embodiment further provides the following advantages.
(35) The wiring layer 528 includes the composite portion 231a and the copper layers 231b sandwiching the composite portion 231a. Therefore, it is easy to set the coefficient of thermal expansion and the thermal conductivity of the wiring layer 528 to appropriate values corresponding to the semiconductor device 18 and the electronic components mounted on the wiring layer 528.
(36) Since the wiring layer 528 is made of a metal composite material, a circuit pattern can be formed by etching. That is, a circuit pattern is more easily formed than in the second embodiment.

A sixth embodiment of the present invention will now be described with reference to Fig. 14. In the sixth embodiment, a single cooling portion 616 is provided. The sixth embodiment is different from the third embodiment in that all the wiring layers 312 are located in corresponding sections of a common flat portion 616b. Further, the sixth embodiment is different from the third embodiment in that cooling medium channels 616a are provided in portions that do not correspond to the wiring layers 312. The remainder of the configuration is the same as those of the third embodiment.

Fig. 14 corresponds to Fig. 8B, and schematically shows a cross-section of a circuit board 610. Two rows of the wiring layers 312 and a single channel 614c are provided in the substrate 311. The channel 614c has width that overlaps both rows of the wiring layers 312. In the channel 614c, a single cooling portion 616 is embedded to form a part of the cooling medium passage 614. The cooling portion 616 has in it a plurality of cooling medium channels 616a spaced at equal intervals. The cooling medium channels 616a extend parallel to the channel 614c (in a direction perpendicular to the elevation of Fig. 14). The flat portion 616b is formed to overlap sections corresponding the two rows of the wiring layers 312. On a side opposite to the flat portion 616b in relation to the cooling medium channels 616a, a flat portion 616c having the same size as the flat portion 616b is formed. The wiring layers 312 are arranged in two rows at predetermined intervals on the flat portion 616b. The wiring layers 312 are arranged along a direction in which the cooling medium channels 616a extend, that is, in a direction perpendicular to the elevation of Fig. 14. As described above, all the wiring layers 312 are located in corresponding sections of the common flat portion 616b in the sixth embodiment. The semiconductor device 18 and passive components (not shown) are mounted on each wiring layer 312 with the solder 17 in between.

The circuit board 610 constructed as shown above is used in the same manner as the circuit board 310 according to the third embodiment. When the semiconductor devices 18 mounted on the circuit board 610 are activated and heat is generated by the mounted components, the heat is transferred to the cooling portions 616 via the solder 17, the wiring layers 312, and the insulating layer 313. The heat transferred to the cooling portions 616 is then transferred to cooling medium flowing through the cooling medium channels 616a. The heat is then carried away by the cooling medium. The flat portion 616b is formed to overlap the entire area in which all the wiring layers 312 are located. Heat is transferred from a wiring layer 312 that corresponds to a mounted component generating heat to the flat portion 616b via the insulating layer 313. Then, the heat is transferred to sections of the flat portion 616b other than the section corresponding to the wiring layer 312. The heat transferred to the flat portion 616b is then transferred to cooling medium flowing through the cooling medium channels 616a. The heat is then carried away by the cooling medium.

The circuit board 610 according to the sixth embodiment further provides the following advantages.
(37) All the wiring layers 312 are located in corresponding sections of the common flat portion 616b in the sixth embodiment. Thus, heat generated by the semiconductor devices 18 is transferred to the flat portion 616b via the solder 17, the wiring layers 312, and the insulating layer 313. The heat is then transferred to sections of the flat portion 616b other than sections corresponding to the wiring layers 312 on which the component generating heat is mounted. Therefore, the heat transferred to the cooling portion 616 is more effectively transferred to cooling medium flowing through the cooling medium channels 616a than in the third embodiment.
(38) The cooling medium channels 616a are provided even in sections that do not correspond to the wiring layers 312. Therefore, heat that is transferred to sections of the flat portion 616b other than the sections of the flat portion 616b corresponding to the wiring layers 312 on which the heat generating component is mounted is effectively removed.

It should be apparent to those skilled in the art that the present invention may be embodied in many other specific forms without departing from the spirit or scope of the invention. Particularly, it should be understood that the invention may be embodied in the following forms.

The thicknesses of the wiring layers 12, 230 do not need to be constant. For example, it may be configured that the thickness of the wiring layer 12, 230 changed depending on the coefficients of thermal expansion of the semiconductor device 18 and electronic components mounted on the wiring layer 12, 230. The coefficient of thermal expansion of the material forming the wiring layer 12, 230 is reduced as the thickness of the wiring layer 12, 230 is increased. Therefore, the thickness of the wiring layer 12, 230 is partially changed such that the thickness of a section corresponding to a component having a great coefficient of thermal expansion is smaller than the thickness of a section corresponding to a component having a small coefficient of thermal expansion. In this manner, the wiring layer 12, 230 having partially changed coefficient of thermal expansion is obtained. On the other hand, the coefficients of thermal expansion of the semiconductor device 18 and the electronic components mounted on the wiring layer 12, 230 are different from one another. Therefore, if the thickness of the wiring layer 12, 230 is changed depending on the coefficient of thermal expansion of the mounted components, unwanted stress is further effectively prevented from being applied to soldered joints in cooling-heating cycles.

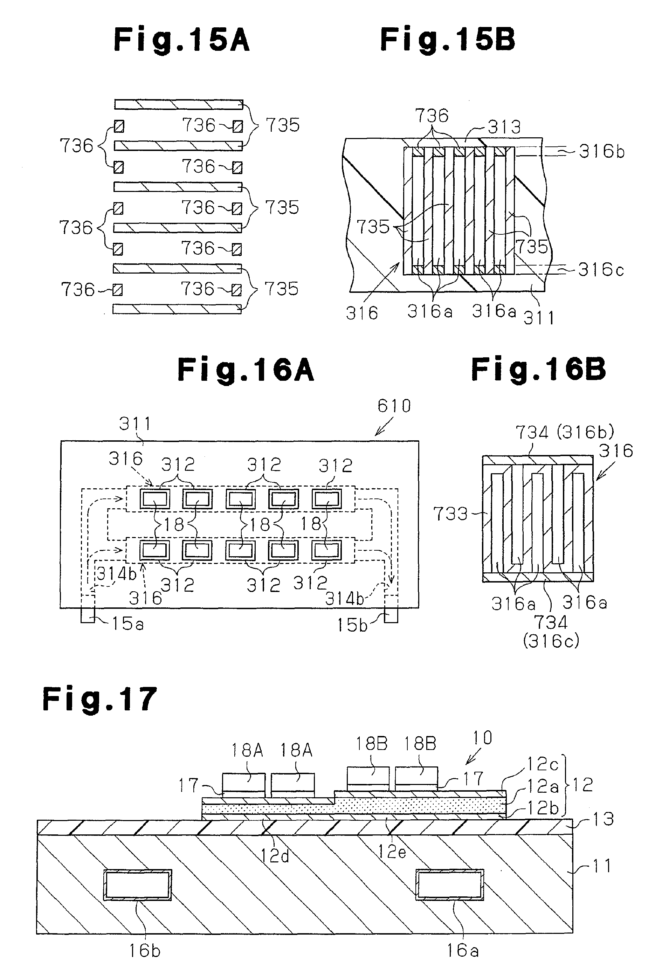

In a configuration where the thickness of the wiring layer 12, 230 partially vary, the thickness of the wiring layer 12, 230 does not need to vary depending on the coefficient of thermal expansion of each component mounted on the wiring layer 12, 230. For example, as shown in Fig. 17, the wiring layer 12 may have a first section 12d on which a number of components 18A having a relatively large coefficient of thermal expansion are mounted, and a second section 12e on which a number of components 18A having a relatively small coefficient of thermal expansion are mounted. The wiring layer 12 may have two different thicknesses. That is, the first section 12d may be thinner than the second section 12e. That is, the thickness of each section 12d, 12e of the wiring layer 12 is determined depending on the coefficient of thermal expansion of the component 18A, 18B mounted on that section 12d, 12e.

In the case where the thickness of the wiring layer 12, 230 is varied to vary the coefficient of thermal expansion of the wiring layer 12, 23, instead of making the ratio of the thickness of the AlSiC portion 12a to the thickness of the aluminum layer 12b, 12c constant or making the ratio of the thickness of the composite portion 231a to the thickness of the copper layer 231b constant, these ratios may be changed to vary the coefficient of thermal expansion.

The AlSiC portion 12a may be formed by pouring aluminum into gaps in pressurized powder of SiC before baking.

The insulating layer 13 shown in Figs. 1A and 4 dos not need to be formed of resin, but maybe formed of ceramics. The ceramics may be aluminum nitride (AlN) or boron nitride (BN). In this case, since the thermal conductivity is higher than resin, the thermal resistance of the insulating layer 13 is reduced, and the cooling efficiency is improved.

The structure of the cooling medium passage 16 provided in the substrate 11 shown in Figs. 1A and 4 is not limited to the one in which the parallel channels 16c are formed by using a core. For example, a pipe may be cast in to form the cooling medium passage 16. The pipe is not limited to a single bent pipe. That is, two or more pipes may be cast in. Alternatively, a pipe that is branched into several channels and then merged into a single channel may cast in. In the case where pipes are cast in, the substrate 11 having the cooling medium passage 16 is easily manufactured compared to the method using a core.

The cooling medium that flows through the cooling medium passage 16 is not limited to water, but may be other types of liquid or air.

In the case shown in Fig. 2, both pipes 15a, 15b project in a same side face of the substrate 11. However, as shown in Fig. 8A, the pipes 15a, 15b may project from different side faces.

A heat pipe may be used as the pipe. If a heat pipe is used, cooling medium automatically circulates through the pipe, and heat of the substrate 11 is effectively radiated to the outside. Thus, the cooling medium circuit 118 is not required, which simplifies the entire structure.

Any metal composite material may be used for the wiring layer 12 shown in Fig. 1A as long as its coefficient of thermal expansion is greater than silicon semiconductor chips and less than copper. For example, in the first embodiment, AlSiC portion 12a, which is a combination of silicon carbide and aluminum, may be replaced by some other composite material. Instead of fine particles of silicon carbide, ceramics of a superior thermal conductivity, for example, boron nitride (BN), magnesium oxide (MgO), or molybdenum disilicide (MoSi₂) may be used. Instead of an aluminum alloy, other metal having a higher thermal conductivity may be used. For example, copper may be used. In the second embodiment shown in Fig. 4, the material of the expanded metal sheet 232 is not limited to invar. For example, other types of invar alloy such as super invar, stainless invar may be used. Alternatively, fernico (alloy containing 54% of weight of Fe, 31% of weight of Ni, and 15% of weight of Co) may be used.

The insulating layer 313 shown in Fig. 8A is made of a thermosetting resin. In this case, instead of bonding the partially cured sheet 320 to the molded part 319 as shown in Fig. 10, an uncured thermosetting resin in which filler is mixed may be applied to the molded part 319 in a predetermined thickness, and then thermally cured. In this case, the insulating layer 313 having a small thickness can be easily formed to have a predetermined thickness.

The insulating layer 313 does not necessarily need to be formed of the same insulating resin used for forming the portions of the substrate 311 other than the insulating layer 313. However, to reduce the thermal resistance of the insulating layer 313, a filler is preferably mixed in the insulating layer 13 so that the thermal conductivity of the insulating layer 313 is higher than in the case where the insulating layer 313 is formed solely of a resin.

The resin for forming portions of the substrate 311 other than the insulating layer 313 does not necessarily need to be an insulating resin. In this case, the filler mixed in the resin of the substrate 311 may be metal.

The cooling portion 316 shown in Fig. 8A does not necessarily need to be formed by the extrusion molding, but may be formed of the die casting. The configuration shown in Fig. 16B may be used in which a pair of flat plates 734 are brazed to both sides of a bent plate member 733. In the configuration shown in Fig. 16B, the pair of flat plates 734 function as the flat portions 316b, 316c. The spaces defined by the plate member 733 and the flat plates 734 serve as the cooling medium channels 316a. The flat plate 734 forming the flat portion 316c located on a side opposite to the side of the flat portion 316b facing the insulating layer 313 does not need to be formed of metal, but may be formed of a resin.

As shown in Fig. 15A, rectangular first plate members 735 and pairs of narrow second plate members 736 each having a rectangular cross section may be alternately laminated and subjected to the hot pressing to form the cooling portion 316. As shown in Fig. 15B, the portions in which the first plate members 735 and the second plate members 736 are alternately laminated may be used as the flat portions 316b, 316c.

The structure of the cooling medium passage 314 in the substrate 311 is not limited to the one shown in Fig. 8C, in which the inlet 314a is provided at one end of the substrate 311 in the longitudinal direction, and the outlet 314b is provided at the other end. For example, as shown in Fig. 16A, the inlet 314a and the outlet 314b may extend in a direction perpendicular to the longitudinal direction of the substrate 311. The pipes 15a, 15b may projection from a common side surface of the substrate 311.

In the cooling portion 316 shown in Fig. 8B, as long as the flat portion 316b is formed in a portion corresponding to the wiring layers 312, the flat portion 316c opposite to the flat portion 316b may be omitted.

The cooling portion 316 shown in Fig. 8B may be simultaneously formed with the insulating layer 313 when an insulating resin is molded by the extrusion molding or the transfer molding. In this case, not only the cooling portion 316, but also, the wiring layers 312 may be placed in predetermined positions in the mold, so that a process for subsequently bonding the wiring layers 312 to the insulating layer 313 can be omitted. In the case where the wiring layer 312 is formed of a metal composite material containing a single metal or a plurality of metals, the extrusion molding or the transfer molding is performed in a state where a metal plate having a shape that corresponds not to the shape of the insulating layers 313 but to the flat portion 316b is fixed to the insulating layer 313. Thereafter, the etching may be performed to form the wiring layers 312.

The cooling portion 316 shown in Fig. 8B does need to have a plurality of parallel cooling medium channels 316a. For example, only a single cooling medium channel 316a may be provided. Further, a cooling medium channel 316a may be provided to correspond to each of the rows of the wiring layers 312. Alternatively, fins may be provided to project into the cooling medium channels 316a.

The method for forming the cooling portion 316 shown in Fig. 8C is not limited to the extrusion molding, the die casting, and the machining and bonding plate members. For example, the cooling medium channels 316a maybe formed of pipes, and a plate member having a flat portion may be bonded to at least a section corresponding to the wiring layers 312. The pipe does not necessarily need to be a single bent pipe. A pipe that is branched into several channels and then merged into a single channel may be employed.

The cooling portion 316 shown in Fig. 8C may be configured such that the outlet 314b and the channels 314c are integrally formed.

The pipe forming the cooling medium channels 316a shown in Fig. 8A may be a heat pipe.

The cooling medium channels 316a shown in Fig. 8A do not necessarily need to extend in the direction of the arrangement of the wiring layers 312, but may extend in directions perpendicular to the arrangement direction of the wiring layers 312.

The numbers of the inlet 314a and the outlet 314b of the cooling medium passage 314 shown in Fig. 8A may be increased.

The fourth embodiment shown in Fig. 11A and the fifth embodiment shown in Fig. 12A may be provided with the cooling medium channels 616a of the sixth embodiment shown in Fig. 14.

In the third embodiment shown in Fig. 8A and the sixth embodiment shown in Fig. 14, the wiring layers 312 may be formed of aluminum. However, from the view point of electrical resistance, the wiring layers 312 are preferably formed of copper.

Two or more semiconductor devices 18 or other electronic components may be mounted on a single wiring layer 312, 425, 528. Accordingly, the number of the wiring layers 312, 425, 528 may be reduced to one.

The wiring layers 312 , 425, 528 do not necessarily need to be arranged in two rows, but may be arranged in a single row or three or more rows depending on the number of the wiring layers 312, 425, 528 or the shape of the substrate 311.

With regard to the insulating layer 313 shown in Fig. 8B, as long as a required insulating property is ensured, the filler for reducing the coefficient of thermal expansion and increasing the thermal conductivity is not limited to insulating ceramics. For example, a conductive ceramics filler or a metal filler may be used.

The insulating layer 313 shown in Fig. 8C may be provided only in the sections corresponding to the wiring layers 312. In such a case, the flat portion 316b is exposed to the outside except for the sections corresponding to the wiring layers 312.

The cooling medium that flows through the cooling medium passage 314 of Fig. 8A is not limited to water, but may be other types of liquid or air.

Any metal composite material may be used for the wiring layer 312 shown in Fig. 8B as long as its coefficient of thermal expansion is greater than silicon semiconductor chips and less than copper. For example, in the fourth embodiment of Fig. 11A, the compositions of the AlSiC portion 12a, which is a combination of silicon carbide and aluminum, may be changed. For example, silicon carbide particles may be replaced by particles of ceramics having a high thermal conductivity such as boron nitride (BN), magnesium oxide (MgO), molybdenum disilicide (MoSi₂), and aluminum may be replaced by a metal having a higher thermal conductivity than aluminum, such as copper. In the fifth embodiment shown in Fig. 12A, the material of the expanded metal sheet 232 is not limited to invar. For example, other types of invar alloy such as super invar, stainless invar may be used. Also, fernico may be used.

As the wiring layers 312 shown in Fig. 8B, a DBA substrate (Al/AlN/Al), in which an aluminum nitride (AlN) layer is sandwiched between aluminum layers, a DBC substrate (Cu/AlN/Cu), in which an aluminum nitride layer is sandwiched between copper layers, a silicon nitride (SiN) substrate, an alumina (Al₂O₃) layer, or a silicon carbide (SiC) substrate may be used. The DBA substrate and the cooling portion may be integrally formed when the extruding molding is performed. In this case, the insulating resin is used for bonding the DBA substrate to the cooling portion.

The wiring layers 312 shown in Fig. 8B may be formed of Al, Cu, and the insulating layer 313 may be formed of AlN, SiN, and alumina. The insulating layer 313 may be bonded to the wiring layers 312 by brazing or diffused junction in advance, and may be bonded to the cooling portion 316 during the extrusion molding of a low-expansion resin. In this case, the insulating resin is used for bonding the wiring layers 312 to the cooling portion 316.

For example, alumina (Al₂O₃) or AlN is sprayed onto a water-cooled heat sink made of Al to forma a film. The cooling portion 316 is formed by brazing Al, Cu onto the film, and the film is integrally molded with a low expansion resin in the injection molding.

A circuit board (10) includes a substrate (11) having a heat exhausting function. A wiring layer (12, 230) of a metal composite material is provided on the substrate (11) with an insulating layer (13) in between. The metal composite material has a coefficient of thermal expansion that is greater than a coefficient of thermal expansion of a silicon semiconductor chip (18) and less than a coefficient of thermal expansion of copper. Accordingly, a circuit board that is suitable for mounting power devices, requires no heat sink or heat spreader is provides. Further, the number of components for assembling a module is reduced (Fig. 1A).

## Claims

1. A circuit board (10, 210, 410, 510) being
**characterized by**:
a substrate (11) having a heat exhausting function; and
a wiring layer (12, 230) of a metal composite material provided on the substrate (11) with an insulating layer (13) in between, the metal composite material having a coefficient of thermal expansion that is greater than a coefficient of thermal expansion of a silicon semiconductor chip (18) and less than a coefficient of thermal expansion of copper.

2. The circuit board (10, 210, 410, 510) according to claim 1,
**characterized in that** the thickness of each section (12d, 12e) of the wiring layer (12) is determined depending on the coefficient of thermal expansion of a component (18A, 18B) mounted on that section (12d, 12e).

3. The circuit board (10, 210, 410, 510) according to claim 1 or 2,
**characterized in that** the thermal conductivity of the wiring layer (12, 230) is equal to or more than 30 W/(mK).

4. The circuit board (10, 410) according to any one of claims 1 to 3,
**characterized in that** the wiring layer (12) includes an AlSiC based composite material portion (12a), and a pair of aluminum layers (12b, 12c) provided on both sides of the AlSiC based composite material portion (12a) to sandwich the AlSiC based composite material portion (12a).

5. The circuit board (210, 510) according to any one of claims 1 to 3,
**characterized in that** the wiring layer (230) includes a composite portion (231a) of copper and invar, and a pair of copper layers (231b) provided on both sides of the composite portion (231a) to sandwich the composite portion (231a).

6. The circuit board (10, 210, 410, 510) according to any one of claims 1 to 5,
**characterized in that** the substrate (11) has a cooling medium passage (16, 314), through which cooling medium flows.

7. The circuit board (10, 210, 410, 510) according to claim 6,
**characterized in that** the cooling medium passage (16, 314) is configured to be connectable with a cooling medium circuit (118) mounted on a vehicle.

8. The circuit board (10) according to claim 6, **characterized in that** the cooling medium passage (16, 314) is formed by a heat pipe.

9. The circuit board (10, 210, 410, 510) according to any one of claims 1 to 8,
**characterized in that** the insulating layer (13) is formed of a resin having an adhesion function.

10. A circuit board (310, 410, 510, 610) comprising:
a substrate (311) having a resin area formed of resin;
a metal cooling portion (316) embedded in the resin area, the cooling portion (316) having a cooling medium passage (316a); and
a wiring layer (312) provided on the substrate (311) with an insulating layer (313) in between, wherein a silicon semiconductor chip (18) is mountable on the wiring layer (312),
the circuit board being **characterized in that**:
at least a section of the cooling portion (316) that corresponds to the wiring layer (312) has a flat portion (316b), and
the resin area has a coefficient of thermal expansion smaller than a coefficient of thermal expansion of the cooling portion (316).

11. The circuit board (310, 410, 510, 610) according to claim 10,
**characterized in that** the resin area and the insulating layer (313) are formed of the same insulating resin.

12. The circuit board (310) according to claim 10 or 11,
**characterized in that** the wiring layer (312) is one of a plurality of wiring layers (312), and
wherein the wiring layers (312) are commonly provided on the common flat portion (316b).

13. The circuit board (310, 410, 510, 610) according to claim 12,
**characterized in that** the wiring layers (312) define a direction of arrangement of the wiring layers (312), and
wherein the cooling medium passage (316a) is configured to extend along the arrangement direction.

14. The circuit board (310, 410, 510, 610) according to any one of claims 10 to 13,
**characterized in that** the cooling portion (316) is made of an aluminum based metal.

15. The circuit board (410, 510) according to any one of claims 10 to 14,
**characterized in that** the wiring layer (312) is made of a metal composite material (426, 529), the metal composite material (426, 529) having a coefficient of thermal expansion that is greater than a coefficient of thermal expansion of the silicon semiconductor chip (18) and less than a coefficient of thermal expansion of copper.

16. The circuit board (310, 410, 510, 610) according to any one of claims 10 to 15,
**characterized in that** the thermal conductivity of the wiring layer (312) is equal to or more than 30 W/(mK).

17. The circuit board (410) according to claim 15 or 16,
**characterized in that** the metal composite material (426) includes an AlSiC portion (12a), and a pair of aluminum layers (12b, 12c) provided on both sides of the AlSiC portion (12a) to sandwich the AlSiC portion (12a).

18. The circuit board (510) according to claim 15 or 16,
**characterized in that** the metal composite material (529) includes a composite portion (231a) of copper and invar, and pair of copper layers (231b) provided on both sides of the composite portion (231a) to sandwich the composite portion (231a).

19. The circuit board (310, 410, 510, 610) according to any one of claims 10 to 18,
**characterized in that** the cooling medium passage (314) is configured to be connectable with a cooling medium circuit (118) mounted on a vehicle.

20. The circuit board (310, 410, 510, 610) according to any one of claims 10 to 19,
**characterized in that** the cooling medium passage (314) is formed by a heat pipe.
